# EUROPEAN PATENT APPLICATION

(11) **EP 0 575 166 A1**
(43) Date of publication of application: **22.12.1993**
(21) Application number: 93304707.8
(22) Date of filing: 16.06.1993
(51) Int. Cl.: C23C 14/34, H01J 37/34

(54) **Method of manufacturing sputtering target assembly and target assembly**

(30) Priority: 16.06.1992 US 900061
(71) Applicant: JOHNSON MATTHEY ELECTRONICS INC, Spokane, Washington 99216 (US)
(72) Inventor: Dunlop, John A., Veradale, WA 99037 (US); Delano, Robert G., Valleyford, WA 99036 (US); Meyer, David R., Spokane, WA 99207 (US); Pouliquen, Benoit Y., Spokane, WA 99216 (US); Strothers, Susan D., Spokane, WA 99207 (US)
(74) Representative: Wishart, Ian Carmichael

(57) **Abstract**

A method of producing a sputtering target assembly by forge cladding a backing member and target member together and a sputtering target assembly capable of withstanding sputtering power levels greater than about 12 kw.

## Description

### Background of the Invention

It is well known that thin metallic and ceramic layers may be deposited upon a substrate by a technique known as "magnetron sputtering". By such methods, a metal layer may be sputtered in an argon atmosphere using a target of the material to be deposited, generally as a cathode in a standard RF sputtering apparatus.

More recently, sputtering techniques have been used in the production of integrated circuits which require rapid and economical metal deposition with very close tolerances. Sputtering is an especially useful tool for the application of films and coatings where uniformity and chemical purity is important. Manufacturing costs may be lowered by improving film uniformity and deposition rate in high speed production processes typically used in integrated circuit manufacturing. Materials of particular importance in the manufacture of integrated circuits are titanium, aluminum and aluminum alloys. Targets of titanium, aluminum and/or aluminum alloys are used for sputtering to produce a metal film or coating on a substrate.

Sputtering processes and apparatus are disclosed in Bergmann et al., U.S. Patent 4,889,772 and 4,961,831; Shagun et al., U.S. Patent 4,961,832; Shimamura et al., U.S. Patent 4,963,239; Nobutani et al., U.S. Patent 4,964,962; Arita, U.S. Patent 4,964,968; Kusakabe et al., U.S. Patent 4,964,969 and Hata, U.S. Patent 4,971,674; and the references referred to therein; sputtering targets are discussed also in Fukasawa et al., U.S. Patent 4,963,240 and 4,966,676; and Archut et al., U.S. Patent 4,966,677. These disclosures of sputtering processes and apparatus as well as sputtering targets are expressly incorporated herein by reference.

Sputtering target assemblies are typically constructed with a target member supported on a backing member. The target member includes a target surface of material to be sputtered and the backing member is intended to hold the target member in place in a sputtering apparatus.

One problem which has arisen with respect to target assemblies is distortion which may occur during manufacture of the target assembly from the heat input into members being joined. Conventional methods of manufacturing target assemblies have included TIG welding, brazing, soldering with high temperature solder, and explosion-bonding of the target member to a backing assembly. These methods of bonding generally involve the use of a filler material.

A conventional target assembly design utilizes annular targets positioned on a fixed backing plate and typically retained in place by soldering or joining as described above. In general where the sputtering target is physically joined to the backing plate, (i.e., by welding, roll cladding or explosive bonding), it is usually removable as a unit into and out of the sputtering system.

Annular targets are preferred to facilitate cooling and circulation of coolant to the target assembly. However, where the target and backing members are of dissimilar materials, problems can arise due to the materials different thermal expansion rates. A soldered joint can be adversely affected and result in premature failure of the target assemblies. Solder alloys typically used for joining the target to the backing member have relatively low melting points and therefore cannot withstand high temperatures.

### Summary of the Invention

The present invention provides a method of manufacturing a sputtering target assembly and a new such assembly with superior properties and capability.

According to the present invention, a sputtering target assembly is manufactured of a target member and a backing member. The method comprises providing a target member and a backing member to be joined by forge cladding. The surface of the target member intended to be joined to the backing member may be advantageously provided with grooves to increase the amount of surface area in contact with the backing member to promote mechanical bonding across the interface. Both and target member and backing member are preheated and then "forge cladded" together, such as in a forge press. The backing member deforms under load of the forge to obtain intimate contact of the backing and target members and mechanical bonding together. Preferably, at least one of the target or backing members is grooved to increase the surface area for additional mechanical bonding. The resulting assembly is then heated to diffusion bond the components together.

In a preferred embodiment, the backing member is made of stainless steel, copper or copper alloys, aluminum or aluminum alloys and the target member is titanium, copper or aluminum. After being diffusion bonded together in the manner described, the target and backing members are firmly held together and the surface-to-surface contact areas form a high strength joint. After diffusion bonding, the bond between the backing member and the target member is stronger than obtained by conventional soldering, and at least equal in strength to roll cladding but without the waste resulting from roll cladding, and the target is able to be used at higher power because the thus bonded target assembly can withstand higher temperatures. It has been determined that the target assembly produced by the above described method can withstand high sputter power levels, i.e., power levels greater than 12 kw.

### Description of Preferred Embodiment

As indicated previously, the forge cladding process of the invention can be used for various combinations of materials where one of the materials is more easily deformed at an elevated temperature while the other material has sufficient strength and ductility to withstand the load applied during deformation of the other material. For example, useful combinations for manufacturing sputtering target assemblies are titanium-to-aluminum, titanium-to-copper and aluminum-to-copper. Other combinations with the requisite comparative and relative strengths and ductility may also be employed.

In addition to the foregoing, it is important in practicing the invention that the materials involved can be diffusion bonded, preferably within a reasonable amount of time for industrial and commercial applications, after the initial mechanical bonding operation. Such a procedure increases the bond strength at the interface of the two dissimilar materials.

As one example of the practice of the invention, the following procedure was employed to accomplish the forge cladding of titanium-to-aluminum: titanium and aluminum target and backing members, respectively, were preheated to about 665°F. The grades of titanium and aluminum used were, respectively, CP-2 titanium and so called "four nines" purity aluminum, i.e., 99.99%. The titanium targets were grooved on the surface intended to contact the aluminum member. The forge platens were heated to about 650°F to minimize heat loss and a maximum force of about 800 tons was applied during forging. The diffusion bonding cycle applied to these mechanically bonded members was 500°C for 24 hours. Six strength readings for ultimate stress from various locations in one clad piece are given in Table I.

**TABLE I**

| SHEAR LUG TEST | |
|---|---|
| Test | Ultimate Stress (psi) |
| 1 | 9,757 |
| 2 | 11,957 |
| 3 | 11,926 |
| 4 | 10,519 |
| 5 | 10,053 |
| 6 | 9,707 |
| | Ave. 10,653 psi |

It should be noted that the preheat temperatures and diffusion bonding cycles may vary depending upon the particular materials used, for example, titanium-to-aluminum where both high purity and commercial aluminum alloys are used, high purity titanium, i.e., 99.995%, or CP-2 grade titanium, etc. For other combinations such as titanium-to-copper the temperatures and diffusion cycles will also vary and optimum conditions depend upon the particular equipment, size of the members to be bonded, and commercial limitations, such as time available and equipment specifications.

It is apparent from the foregoing that various changes and modifications may be made without departing from the spirit of the invention. Accordingly, the scope of the invention should be limited only by the appended claims wherein what is claimed is:

## Claims

1. A method of producing a sputtering target assembly comprising a backing member and a target member comprising:
preheating the backing member and target members to an elevated temperature less than their respective melting points;
assembling the preheated members with the surface of one member in intimate face-to-face contact with a surface of the other member;
applying sufficient force to mechanically bond the members together; and
diffusion bonding the backing member and the target member together to produce a diffusion bonded sputtering target assembly.

2. A method according to claim 1 further comprising grooving the surface of at least one of the target and backing members and applying sufficient force to cause the grooved surface to penetrate the other member to mechanically bond the members together.

3. A method according to claim 1 wherein said sputtering target member is from the group consisting of stainless steel, titanium, titanium alloys, aluminum, aluminum alloys, copper and copper alloys, and the backing member is from the group consisting of aluminum, aluminum alloys, copper and copper alloys.

4. A method according to claim 1 wherein said force is applied in a forging press and to produce a forge cladded sputtering target assembly with bond strength greater than may be obtained by soldering or welding such members together.

5. A forge cladded sputtering target produced according to claim 4 which is capable of withstanding sputtering power levels greater than about 12 kw.

6. A forge cladded sputtering target assembly according to claim 5 wherein the target member is from the group consisting of stainless steel, titanium, titanium alloys, aluminum, aluminum alloys, copper and copper alloys, and the backing member is from the group consisting of aluminum, aluminum alloys, copper and copper alloys.
